(19) Europäisches Patentamt
European Patent Office
Office européen des brevets

(11) **EP 3 365 784 B1**

(12) **EUROPÄISCHE PATENTSCHRIFT**

(45) Veröffentlichungstag und Bekanntmachung des Hinweises auf die Patenterteilung:
**21.08.2019 Patentblatt 2019/34**

(21) Anmeldenummer: **16787765.3**

(22) Anmeldetag: **18.10.2016**

(51) Int Cl.:
*G06F 11/07* (2006.01)    *G01R 31/00* (2006.01)

(86) Internationale Anmeldenummer:
**PCT/EP2016/074979**

(87) Internationale Veröffentlichungsnummer:
**WO 2017/067928 (27.04.2017 Gazette 2017/17)**

(54) **SCHALTUNGSANORDNUNG UND VERFAHREN ZUR ÜBERWACHUNG EINES MIKROCONTROLLERS AUF DER GRUNDLAGE EINER WÄCHTERSPANNUNG**

CIRCUIT ASSEMBLY AND METHOD FOR MONITORING A MICRO-CONTROLLER BASED ON A WATCHDOG VOLTAGE

AGENCEMENT DE CIRCUITS ET PROCÉDÉ DE SURVEILLANCE D'UN MICROCONTRÔLEUR À BASE D'UNE TENSION DE SURVEILLANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.10.2015 DE 102015117977**

(43) Veröffentlichungstag der Anmeldung:
**29.08.2018 Patentblatt 2018/35**

(73) Patentinhaber: **KNORR-BREMSE Systeme für Nutzfahrzeuge GmbH
80809 München (DE)**

(72) Erfinder:
• **GSCHEIDLE, Wolfgang
71720 Oberstenfeld (DE)**
• **BEYSE, Thorsten
73265 Dettingen (DE)**

(56) Entgegenhaltungen:
**WO-A2-2009/040216    DE-A1-102013 226 429
US-A- 4 243 975    US-A1- 2010 176 891
US-B1- 6 463 546**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 365 784 B1

**Beschreibung**

Die Erfindung betrifft eine Schaltungsanordnung, und bezieht sich insbesondere auf eine digitale Wächter- oder Watchdog (WD)-Schaltung zur Überwachung des zeitlichen Verhaltens oder Timingverhaltens eines Mikrocontrollers. Ferner betrifft die Erfindung ein Verfahren zur Überwachung eines Mikrocontrollers auf der Grundlage einer Wächterspannung, die ein einer Wächter-Schaltungsanordnung erzeugt wird.

Durch steigenden Kostendruck bei der Entwicklung von elektronischen Systemen erfolgt zunehmend eine Umstellung solcher Systeme von bisher eingesetzten Multi- oder Mehrrechner-Systemen auf Einrechner-Systeme. Aufgrund ebenfalls steigender Forderungen nach funktionaler Sicherheit, beispielsweise auf dem Gebiet der Fahrzeuge und insbesondere dem der Nutzfahrzeuge, muss die bisher in Mehrrechner-Systemen zur Verfügung stehende Redundanz auch bei Einrechner-Systemen sichergestellt oder weiter verbessert werden.

Wächter- oder Watchdog-Schaltungen (WD) für das Timingverhalten eines Mikrocontrollers in Form von digitalen Schaltungen und Verfahren (wie beispielsweise eine Fenster-WD, eine auf Frage-Antwort-Sequenzen basierende intelligente WD und dergleichen) sind an sich bekannt. Ebenfalls an sich bekannt sind feste statische Referenzspannung an einem Eingangsanschluss bzw. PIN eines Analog-Digital-Wandlers (ADC) an einem Mikrocontroller, der die korrekte Funktion des ADC sicherstellen soll. Es besteht Bedarf an einer kostengünstigen und gleichzeitig einfach darzustellenden Schaltungsanordnung, die ein einfaches, aber wirksames Überprüfen des Zeitverhaltens eines Mikrocontrollers erlaubt.

DE 10 2013 226429 A1 offenbart eine Schaltungsanordnung zur Überwachung des Timingverhaltens eines Mikrocontrollers, beinhaltend einen Mikrocontroller, der dazu angeordnet ist, zumindest einen Wächterspannungserzeugungsabschnitt zur zeitlich definierten Erzeugung zumindest einer Überwachungsspannung anzusteuern, und den zumindest einen Wächterspannungserzeugungsabschnitt, der dazu angeordnet ist, die erfassbare Überwachungsspannung zu erzeugen, wobei eine erfasste, innerhalb eines vorbestimmten Spannungstoleranzbereichs liegende Überwachungsspannung einen fehlerfreien Zustand des Mikrocontrollers anzeigt, und eine erfasste, außerhalb des vorbestimmten Spannungstoleranzbereichs liegende Überwachungsspannung einen fehlerhaften Zustand des Mikrocontrollers anzeigt. WO 2009/040216 A2 beschreibt eine Fahrzeugsteuereinheit mit einem versorgungsspannungsüberwachten Mikrocontroller, wobei die zu überwachende Spannung vom Mikrocontroller mittels A/D-Wandler erfasst, eingelesen und auf Korrektheit überprüft wird.

Der Erfindung liegt daher als eine Aufgabe zugrunde, für ein Einrechner-System mit einem Mikrocontroller eine Schaltungsanordnung und ein Verfahren zu dessen Überwachung bereitzustellen, mit der bzw. dem analoge (ADC-) Eingänge des Mikrocontrollers auf korrekte Funktion und möglichst gleichzeitig auch noch der Mikrocontroller selbst auf korrektes internes Timing geprüft werden können.

Erfindungsgemäß wird diese Aufgabe durch eine Wächter-Schaltungsanordnung mit den Merkmalen des Patentanspruchs 1 und durch ein Verfahren zur Überwachung eines Mikrocontrollers auf der Grundlage einer Wächterspannung mit den Merkmalen des Anspruchs 9 gelöst. Vorteilhafte Weiterbildungen der Erfindung sind Gegenstand der beigefügten Unteransprüche.

Der Erfindung liegt die allgemeine Idee zugrunde, eine kostengünstige und gleichzeitig einfache Schaltungsanordnung bereitzustellen, die ein einfaches, aber wirksames Überprüfen des Timings bzw. Zeitverhaltens eines Mikrocontrollers erlaubt. Erfindungsgemäß werden die beiden Forderungen nach einer Überprüfung der Funktion eines Analog-Digital-Wandlers und nach einem korrekten Timing des Mikrocontrollers ($\mu$C) vereint. Die Schaltung benötigt in nachstehend beschriebenen Ausführungsbeispielen nur fünf bis acht kostengünstige Standardbauteile. Eine notwendige eigenständige Referenzspannung kann wahlweise auch von einem anderen Schaltungsteil zur Verfügung gestellt werden, so dass hierzu keine zusätzlichen Bauteile benötigt werden.

Genauer wird unter Verwendung einer hochstabilen Referenzspannung, deren Wert genau bekannt ist, und bekannter Toleranzen verwendeter Bauteile, die einen erlaubten oder zulässigen Bereich für einen Spannungserfassungswert festlegen, ein Kondensator zunächst vollständig entladen und dann beginnend zu einem bestimmten Zeitpunkt entlang einer Ladekurve, die durch ein Zeitglied bestimmt wird, wieder geladen. Ab diesem bestimmten Zeitpunkt ist die Aufladezeit bis zu einer bestimmten Spannung, im vorliegenden Fall der zu erfassenden Überwachungsspannung, die der Mikrocontroller nach dieser Zeit einlesen wird, genau bekannt. Die Aufladezeit wird durch den Mikrocontroller exakt vorgegeben und ist somit ein absolutes Maß für die rückzulesende Spannung. Durch die strenge Abhängigkeit der Ladezeit und des Werts der Überwachungsspannung geht die absolute Ladezeit direkt in das Ergebnis mit ein. Ändert sich diese absolute Ladezeit durch beispielsweise ein abweichendes Timing oder eine Fehlfunktion innerhalb des Mikrocontrollers, ändert sich die Überwachungsspannung proportional dazu. Verlässt die Überwachungsspannung dabei das durch die Bauteiltoleranzen bestimmte Toleranzband, können diese Fehler im Mikrocontroller eindeutig erkannt und das Gesamtsystem in einen sicherheitsunkritischen Betriebszustand gebracht werden.

In Übereinstimmung mit dem Vorstehenden wird die Aufgabe im Einzelnen gelöst durch eine Wächter-Schaltungsanordnung zur Überwachung des Timingverhaltens eines Mikrocontrollers. Die Wächter-Schaltungsanordnung beinhaltet einen Mikrocontroller, der dazu angeordnet ist, zumindest einen Wächterspannungserzeugungsabschnitt zur zeitlich definierten Erzeugung zumindest einer Überwachungsspannung anzusteuern und zu einem vorbestimmten Abtastzeitpunkt die dann erzeugte Überwachungsspannung zu erfassen und einzulesen, und den zumindest einen Wächterspannungserzeugungsabschnitt, der dazu angeordnet ist, die zu einem vorbestimmten Abtastzeitpunkt durch Abtastung durch den Mikrocontroller erfassbare Überwachungsspannung zu erzeugen, wobei eine zu dem Abtastzeitpunkt erfasste, innerhalb eines vorbestimmten Spannungstoleranzbereichs liegende Überwachungsspannung einen fehlerfreien Zustand des Mikrocontrollers anzeigt, und eine zu dem vorbestimmten Zeitpunkt erfasste, außerhalb des vorbestimmten Spannungstoleranzbereichs liegende Überwachungsspannung einen fehlerhaften Zustand des Mikrocontrollers anzeigt.

Dabei weist der Wächterspannungserzeugungsabschnitt zumindest einen Kondensator auf, an dem die Überwachungsspannung bereitgestellt wird. Da der Spannungsverlauf einer Ladekurve an einem Kondensator bei Bauelementen, deren Parameter bekannt sind, ebenfalls bekannt ist, kann vorteilhaft eine einfache Spannungsabtastung dargestellt werden.

Dabei weist der Wächterspannungserzeugungsabschnitt zumindest einen Transistor auf, der parallel zu dem Kondensator verschaltet und in Abhängigkeit von einem logischen Zustand an einem Ausgang des Mikrocontrollers durch den Mikrocontroller zeitgesteuert schaltbar ist, wobei während eines Zustands von logisch 0 des Ausgangs der Transistor gesperrt wird und der Kondensator definiert ladbar ist, und während eines Zustands von logisch 1 des Ausgangs der Transistor durchgeschaltet wird und der Kondensator definiert entladbar ist. Ein Transistor als Schaltelement ist im zugrundeliegenden Spannungs- und/oder Leistungsbereich eine vorteilhaft kostengünstige Möglichkeit, die Aufladung und/oder die Entladung eines Kondensators zusteuern.

Hierbei ist der Kondensator dazu angeordnet, um gesteuert durch den Mikrocontroller über den Transistor zu einem beliebigen Zeitpunkt vollständig entladen zu werden, und aus dem entladenen Zustand zu einem vorbestimmten Zeitpunkt geladen zu werden, wobei die Kondensatorspannung und zu einem nachfolgenden Abtastzeitpunkt die Überwachungsspannung an dem Kondensator gemäß der eine Ladekurve definierenden Gleichung $U(c/1/2) = U_{Ref} * (1 - exp(-t_{Lade}/R*C)$ entstehen, worin Uc oder U1 und/oder U2 die Überwachungsspannung ist, die der Mikrocontroller nach einer bekannten Aufladezeit ab dem vorbestimmten Zeitpunkt zu dem Abtastzeitpunkt einlesen wird, $U_{Ref}$ eine hochstabile Referenzspannung ist, deren Wert genau bekannt und bevorzugt aus einem eigenständigen Spannungsregelelement, z.B. einer Referenzdiode, unabhängig von der Versorgungsspannung des $\mu$Cs ist, $t_{lade}$ die bekannte Aufladezeit ist, und R/C ein RC-Glied aus einem Widerstand und dem Kondensator definiert, welches eine Zeitkonstante $\tau = R*C$ festlegt, mit welcher sich der Kondensator auflädt. Vorteilhaft sind somit die zugrunde zu legenden Parameter und Signalverläufe exakt bestimm- und berechenbar.

Zusätzlich ist ein erster Wächterspannungserzeugungsabschnitt vorgesehen, bei dem ein erster erster Widerstand in Reihe mit einem ersten Kondensator verschaltet ist und an einem ersten seiner Enden an einer Referenzspannung liegt, und an einem zweiten seiner Enden mit einem ersten Anschluss des ersten Kondensators verbunden ist; ein Versorgungswiderstand vorgesehen ist, der an einem ersten seiner Enden an einer Versorgungsspannung liegt und an einem zweiten seiner Enden kathodenseitig mit einer Diode verbunden ist, die die Referenzspannung zwischen dem ersten Ende des ersten ersten Widerstands und einem zweiten Anschluss des ersten Kondensators bereitstellt; und ein erster Transistor einen ersten Anschluss, der mit dem ersten Anschluss des ersten Kondensators und einem ersten Analogwandlereingang des Mikrocontrollers verbunden ist, einen zweiten Anschluss, der mit einem ersten Ausgang des Mikrocontrollers verbunden ist, und einen dritten Anschluss, der mit dem zweiten Anschluss des ersten Kondensators, anodenseitig mit der Diode und einem Massepotenzial verbunden ist, aufweist; und ist ein zweiter Wächterspannungserzeugungsabschnitt vorgesehen, bei dem ein zweiter erster Widerstand in Reihe mit einem zweiten Kondensator verschaltet ist und an einem ersten seiner Enden an einer Referenzspannung liegt, und an einem zweiten seiner Enden mit einem ersten Anschluss des zweiten Kondensators verbunden ist; der Versorgungswiderstand die Referenzspannung zwischen dem ersten Ende des zweiten ersten Widerstands und einem zweiten Anschluss des zweiten Kondensators bereitstellt; und der zweite Transistor einen ersten Anschluss, der mit dem ersten Anschluss des zweiten Kondensators und einem zweiten Analogwandlereingang des Mikrocontrollers verbunden ist, einen zweiten Anschluss, der mit einem zweiten Ausgang des Mikrocontrollers verbunden ist, und einen dritten Anschluss, der mit dem zweiten Anschluss des zweiten Kondensators und einem Massepotenzial verbunden ist, aufweist, wobei der erste Wächterspannungserzeugungsabschnitt und der zweite Wächterspannungserzeugungsabschnitt eine mehrkanalige Wächter-Schaltungsanordnung ausbilden.

Bevorzugt werden der erste Wächterspannungserzeugungsabschnitt und der zweite Wächterspannungserzeugungsabschnitt derart zeit- und/oder phasenverschoben angesteuert und abgetastet, dass eine der Überwachungsspannungen an einem der Kondensatoren zu einer ersten vorbestimmten Zeit erfasst und von dem Mikrocontroller eingelesen wird, und eine andere der Überwachungsspannungen an einem anderen der Kondensatoren zu einer zweiten vorbestimmten Zeit erfasst und von dem Mikrocontroller eingelesen wird. Vorteilhaft ist hierdurch eine weiter gehende Erkennung von Einzelfehlern an der Watchdogschaltung möglich, beispielsweise dann, wenn er Mikrocontroller sporadische Taktaussetzer oder einen Defekt des Ansteuerports DO_1 für den Entladetransistor T1 hat. Durch den Defekt bliebe C1 entladen, was nicht erkannt werden würde, wenn der $\mu$C dann aus diesem Stand wieder weiterlaufen würde. C2 würde sich aber durch den Aussetzer des $\mu$Cs weiter aufladen und damit außerhalb des Toleranzfensters fallen, der Fehler würde also durch den zweiten Kanal erkennbar.

Bevorzugt unterscheiden sich die Zeitkonstante des durch den ersten ersten Widerstand und den ersten Kondensator bestimmten Zeitglieds und die Zeitkonstante des durch den zweiten ersten Widerstand und den zweiten Kondensator bestimmten Zeitglieds voneinander. Vorteilhaft können dadurch sogenannte Common-Mode-Störungen besser unterschieden werden.

Bevorzugt werden Abtastungen der Ladekurve des Kondensators zu definierten Abtastzeiten zyklisch wiederholt. Eine zyklische Abtastung gewährleistet eine fortwährende Überwachung des Mikrocontrollers in dessen laufendem Betrieb.

Bevorzugt ist der Mikrocontroller dazu angeordnet, den Transistor bis zur vollständigen Aufladung des Kondensators zu sperren, danach den absoluten Wert der Referenzspannung zu erfassen, und auf der Grundlage des erfassten Werts der Referenzspannung zumindest einen Analog-Digital-Wandlerkanal des Mikrocontrollers zu kalibrieren. Vorteilhaft kann hierdurch die Erfassungsgenauigkeit des Analog-Digital-Wandlers weiter gesteigert werden.

Bevorzugt ist der elektronische Schalter als ein Transistor ausgebildet. Weiter bevorzugt ist der elektronische Schalter in den Mikrocontroller integriert ausgebildet. Alternativ bevorzugt ist der elektronische Schalter außerhalb des Mikrocontrollers liegend vorgesehen und mit diesem verbunden.

Die Aufgabe wird ebenfalls gelöst durch ein Verfahren zur Überwachung eines Mikrocontrollers auf der Grundlage einer Spannung zur Überwachung des Timingverhaltens eines Mikrocontrollers, die in einer zuvor beschriebenen Wächter-Schaltungsanordnung erzeugt wird, mit den Schritten: Ansteuern zumindest eines Wächterspannungserzeugungsabschnitts zur zeitlich definierten Erzeugung zumindest einer Überwachungsspannung, wobei das Ansteuern ein definiertes Entladen eines Kondensators und sodann, beginnend zu einem vorbestimmten Zeitpunkt, definiertes Laden des Kondensators entlang einer Ladekurve beinhaltet; und Erfassen und Einlesen der zu einem vorbestimmten Abtastzeitpunkt erzeugten Ladespannung des Kondensators als die Überwachungsspannung, wobei eine zu dem Abtastzeitpunkt erfasste, innerhalb eines vorbestimmten Spannungstoleranzbereichs liegende Überwachungsspannung einen fehlerfreien Zustand des Mikrocontrollers anzeigt, und eine zu dem vorbestimmten Zeitpunkt erfasste, außerhalb des vorbestimmten Spannungstoleranzbereichs liegende Überwachungsspannung einen fehlerhaften Zustand des Mikrocontrollers anzeigt.

Bevorzugt wird während eines Zustands von logisch 0 eines Ausgangs des Mikrocontrollers ein Transistor gesperrt ist und der Kondensator definiert ladbar, und wird während eines Zustands von logisch 1 des Ausgangs der Transistor durchgeschaltet und ist der Kondensator definiert entladbar.

Bevorzugt wird der Kondensator gesteuert durch den Mikrocontroller über den Transistor zu einem beliebigen Zeitpunkt vollständig entladen und aus dem entladenen Zustand zu einem vorbestimmten Zeitpunkt geladen, wobei die Kondensatorspannung und zu einem nachfolgenden Abtastzeitpunkt die Überwachungsspannung an dem Kondensator gemäß der eine Ladekurve definierenden Gleichung $U(c/1/2) = U_{Ref} * (1 - exp(-t_{lade}/R*C)$ entstehen, worin Uc oder U1 und/oder U2 die Überwachungsspannung ist, die der Mikrocontroller nach einer bekannten Aufladezeit ab dem vorbestimmten Zeitpunkt zu dem Abtastzeitpunkt einlesen wird, $U_{Ref}$ eine hochstabile Referenzspannung ist, deren Wert genau bekannt ist, $t_{lade}$ die bekannte Aufladezeit ist, und R/C ein RC-Glied aus einem Widerstand und dem Kondensator definiert, welches eine Zeitkonstante $\tau = R*C$ festlegt, mit welcher sich der Kondensator auflädt.

Bevorzugt werden ein erster Wächterspannungserzeugungsabschnitt und ein zweiter Wächterspannungserzeugungsabschnitt derart phasenverschoben angesteuert und abgetastet, dass eine der Überwachungsspannungen an einem der Kondensatoren zu einer ersten vorbestimmten Zeit erfasst und von dem Mikrocontroller eingelesen wird, und eine andere der Überwachungsspannungen an einem anderen der Kondensatoren zu einer zweiten vorbestimmten Zeit erfasst und von dem Mikrocontroller eingelesen wird.

Bevorzugt unterscheiden sich eine Zeitkonstante eines RC-Zeitglieds eines ersten Wächterspannungserzeugungsabschnitts und eine Zeitkonstante eines RC-Zeitglieds eines zweiten Wächterspannungserzeugungsabschnitts voneinander.

Bevorzugt werden Abtastungen der Ladekurve des Kondensators zu definierten Abtastzeiten zyklisch wiederholt.

Bevorzugt wird der Transistor bis zur vollständigen Aufladung des Kondensators gesperrt, wird danach der absolute Wert der Referenzspannung erfasst, und wird auf der Grundlage des erfassten Werts der Referenzspannung zumindest ein Analog-Digital-Wandlerkanal des Mikrocontrollers kalibriert.

Die Erfindung wird nachstehend anhand bevorzugter Ausführungsbeispiele unter Bezugnahme auf die Zeichnung näher beschrieben. Es zeigen:

Fig. 1     eine vereinfachte, ausschnittsweise Prinzipdarstellung einer Wächter-Schaltungsanordnung zur Überwachung des zeitlichen Verhaltens oder Timingverhaltens eines Mikrocontrollers;

Fig. 2A und 2B     ausschnittsweise typische Signalverläufe in Form von Spannungsverläufen bei verschiedenen Betriebszuständen in der Wächter-Schaltungsanordnung nach Fig. 1;

| Fig. 3 | eine vereinfachte, ausschnittsweise Prinzipdarstellung einer Wächter-Schaltungsanordnung zur Überwachung des zeitlichen Verhaltens oder Timingverhaltens eines Mikrocontrollers gemäß einem ersten Ausführungsbeispiel; und |
| Fig. 4 | ausschnittsweise typische Signalverläufe in Form von Spannungsverläufen, insbesondere in einem Fehlerfall mit redundanten Kanälen, bei verschiedenen Betriebszuständen in der Wächter-Schaltungsanordnung nach Fig. 3. |

Es wird angemerkt, dass in der Zeichnung äquivalente oder gleich wirkende Elemente dieselben oder zumindest ähnliche Bezugszeichen tragen können und in diesem Fall jeweils nicht nochmals beschrieben werden.

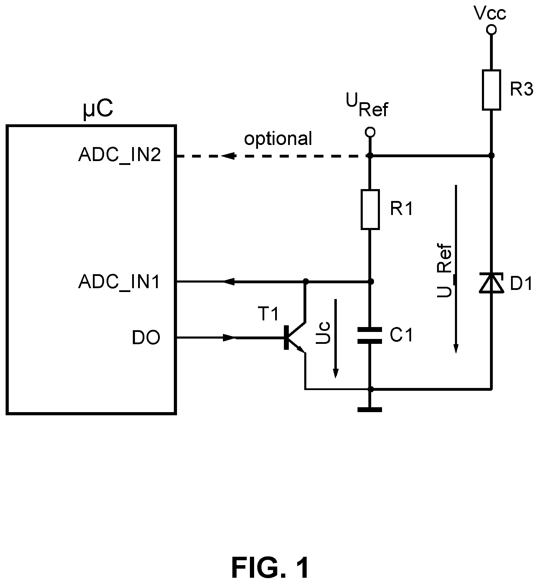

**Fig. 1** zeigt eine vereinfachte, ausschnittsweise Prinzipdarstellung einer Wächter-Schaltungsanordnung zur Überwachung des zeitlichen Verhaltens oder Timingverhaltens eines Mikrocontrollers.

Der in Fig. 1 linksseitig gezeigte Mikrocontroller $\mu C$ ist eine in beispielsweise Systemen, elektronischen Steuereinheiten (ECU) und dergleichen für Fahrzeuge, insbesondere Nutzfahrzeuge, verwendbare Steuereinrichtung und als solcher gut bekannt. Hier weist der Mikrocontroller $\mu C$ neben üblicherweise vorhandenen Ein- und Ausgängen bzw. Ports zumindest einen ersten Analog-Digital-Wandlereingang ADC_IN1 und einen digitalen Ausgang bzw. Digitalausgang DO auf. Es versteht sich, dass weitere Eingänge, beispielsweise ein zweiter Analog-Digital-Wandlereingang ADC_IN2, vorgesehen sein können.

In Fig. 1 rechtsseitig ist ein Wächterspannungserzeugungsabschnitt dargestellt, der zumindest mit dem vorgenannten ersten Analog-Digital-Wandlereingang ADC_IN1 und dem Ausgang DO verbunden ist und zumindest einen Transistor T1, einen Kondensator C1, einen Widerstand R1, eine Diode D1 und einen Widerstand R3 beinhaltet. Eine Verbindung des Wächterspannungserzeugungsabschnitts mit dem zweiten Analog-Digital-Wandlereingang ADC_IN2 kann optional sein, wie noch zu beschreiben ist.

Im Einzelnen ist nach Fig. 1 ein erster Anschluss des Transistors T1, beispielsweise der Drain- oder Kollektor-Anschluss, mit dem ersten Eingang ADC_IN1 des Mikrocontrollers $\mu C$ verbunden, und ist ein zweiter Anschluss des Transistors T1, beispielsweise der Gate- oder Basisanschluss, mit dem Digitalausgang DO verbunden. Ferner ist der erste Anschluss des Transistors T1 mit einem zweiten Ende des Widerstands R1 und einem ersten Anschluss des Kondensators C1 verbunden. Ein zweites Ende des Widerstands R1 liegt an einer Referenzspannung $U_{Ref}$, die über die Diode D1, beispielsweise eine geeignete Zenerdiode, bereitgestellt wird. Die Diode D1 liegt dazu parallel zu der Reihenschaltung aus dem Widerstand R1 und dem Kondensator C1 und wird von dem Widerstand R3 z.B. aus einer Versorgungsspannung Vcc von beispielsweise 5V einer elektronischen Steuereinheit (ECU), in der sowohl der Mikrocontroller $\mu C$ als auch der Wächterspannungserzeugungsabschnitt angeordnet bzw. integriert sind, versorgt. Ein dritter Anschluss des Transistors T1 (Source oder Emitter), ein zweiter Anschluss des Kondensators C1 und die Anodenseite der Diode D1 liegen an einem gemeinsamen Knoten auf einem Massepotenzial.

In der vorgenannten Anordnung liegt damit der Transistor T1, der in dieser Konfiguration einen Entladetransistor für den Kondensator C1 bildet, parallel zu dem Kondensator C1, und liegt die Reihenschaltung aus dem Widerstand R1 und dem Kondensator C1, die in dieser Konfiguration ein RC-Glied R1/C1 bildet, parallel zu der Diode D1.

Der vorstehend beschriebene Transistor T1, der in der beschriebenen Konfiguration als Entladetransistor für den Kondensator C1 arbeitet, kann in einer Modifikation des vorliegenden Ausführungsbeispiels und als Variante eines Mikrocontrollerports auch bereits im Mikrocontroller $\mu C$ integriert sein. In diesem Fall kann der Kondensator C1 direkt mit den entsprechenden Eingangs- und Ausgangsports des Mikrocontrollers $\mu C$ verbunden sein.

Die Spannung ($U_{Ref}$) über der Diode, die über den z.B. an der Versorgungsspannung Vcc liegenden Widerstand R3 geliefert wird, ist bevorzugt eine hochgenaue Referenzspannung, deren Wert genau bekannt und die unabhängig von anderen Versorgungsspannungen ist.

Der Transistor T1 wird von einem digitalen Eingangs/Ausgangs-Port des Mikrocontrollers $\mu C$, in diesem Ausführungsbeispiel dem digitalen Ausgang DO, angesteuert. Solange der Port DO logisch 0 ist, ist der Transistor T1 gesperrt, und lädt sich der Kondensator C1 mit der Zeitkonstanten $\tau$ = R1*C1 auf die Spannung $U_{Ref}$ auf. Die Dimensionierung bzw. die Werte des Widerstands R1, des Kondensators C1 und des Transistors T1 sind genau bekannt, ebenso wie Toleranzen dieser jeweiligen Bauelemente. Somit ist auch die Aufladezeitkonstante bekannt. Toleranzgrenzen, die noch zu beschreiben sind und in diesem Ausführungsbeispiel mit $U_{min}$ (untere Toleranzgrenze) und $U_{max}$ (obere Toleranzgrenze) bezeichnet werden und als solche ein Toleranzband repräsentieren, können fachmännisch berechnet werden.

Wie vorstehend beschrieben wurde, ist der Mikrocontroller $\mu C$ ist dazu angeordnet, über den digitalen Ausgang DO den Transistor T1 anzusteuern, d.h. zu sperren oder durchzuschalten. Daher kann der Mikrocontroller $\mu C$ durch Sperren des Transistors T1 den Kondensator C1 zu einem beliebigen Zeitpunkt vollständig aufladen und danach, beispielsweise zu einem vorbestimmten Zeitpunkt t0, durch Freigeben, d.h. durchlässig Schalten, des Transistors T1 wieder entladen. In anderen Worten kann sich der Kondensator C1 ab dem vorbestimmten Zeitpunkt t0 wieder aufladen.

Die Ladekurve des Kondensators C1 folgt der allgemeinen Gleichung U = $U_{Ref}$ * (1 - exp (-t/R*C)). Mit einer vorbestimmten Aufladezeit $t_{lade}$, die durch den Mikrocontroller $\mu C$ exakt vorgegeben werden kann und die ein absolutes Maß für die von dem Mikrocontroller μC rückzulesende Spannung ist, ergibt sich somit die Kondensatorspannung zu einem Abtastzeitpunkt nach Verstreichen der Aufladezeit $t_{lade}$ aus der Gleichung Uc = $U_{Ref}$ * (1 - exp (-$t_{Lade}$/R1*C1)). In anderen Worten ist damit ab dem Zeitpunkt t0 die Aufladezeit bis zu einer Spannung Uc, die der Mikrocontroller μC nach Verstreichen der Aufladezeit einlesen wird, genau bekannt. Aufgrund der vorstehend erwähnten Toleranzen der Bauteile ist dabei ein gewisses Toleranzband um die Spannung Uc, innerhalb dessen die Spannung Uc auch bei bekannter Aufladezeit und bekannten Werten beteiligter Bauelemente schwanken kann, bei der Überwachung der Spannung Uc zu berücksichtigen.

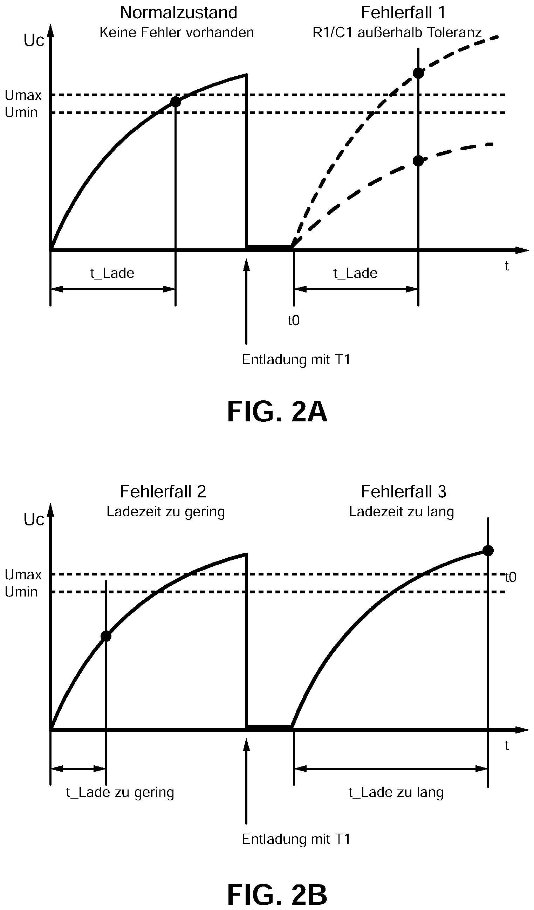

**Fig. 2A** und **Fig.2B** zeigen ausschnittsweise typische Signalverläufe in Form von Spannungsverläufen bei verschiedenen Betriebszuständen in der Wächter-Schaltungsanordnung nach Fig. 1.

In Fig. 2A und 2B ist jeweils entlang der Ordinate die an dem Kondensator C1 anliegende Kondensatorspannung Uc und entlang der Abszisse die Zeit aufgetragen. Insoweit zeigen Fig. 2A und 2B damit eine Ladespannungskurve des Kondensators C1 über der Zeit. Waagrechte durchbrochene Linien, die an der Ordinate mit $U_{max}$ und $U_{min}$ bezeichnet sind, repräsentieren jeweils eine obere und eine untere Toleranzgrenze und insgesamt ein von Toleranzen der verwendeten Bauelemente bestimmtes Toleranzband als einen zulässigen Bereich, in welchem zu einem Abtastzeitpunkt die Kondensator- bzw. Überwachungsspannung Uc für eine Erfassung eines Normalzustands, in dem ermittelt wird, dass kein Fehler bzw. keine Fehlfunktion vorliegt, liegen darf.

Die in Fig. 2A und 2B dargestellten Ladekurven zeigen ausschnittsweise aus zyklischen Wiederholungen von Lade- und Entladevorgängen im Einzelnen den Beginn einer Aufladung des Kondensators C1 zu einem Zeitpunkt, der in Fig. 2A und 2B beispielsweise im Ursprung (0, 0) des Koordinatensystems liegt. Nach Beginn des Ladevorgangs steigt die Überwachungsspannung Uc der vorstehenden Gleichung entsprechend an. Nach Verstreichen einer Zeit t_Lade wird an dem dann erreichten Abtast- oder Samplingpunkt die erreichte Überwachungsspannung Uc von dem Mikrocontroller μC abgetastet und eingelesen bzw. rückgelesen.

Fig. 2A bezieht sich in ihrem rechtsseitigen Teil auf einen Fehlerfall 1, in dem zwar die Aufladezeit t_Lade korrekt ist, aber beispielsweise Werte und/oder Parameter des Zeitglieds R1/C1 außerhalb zulässiger Toleranzen liegen. Bei Erfassung einer außerhalb des Toleranzbands liegenden Kondensator- bzw. Überwachungsspannung Uc zum Abtastzeitpunkt, d.h. einer Kondensator- bzw. Überwachungsspannung Uc kleiner als die untere Toleranzgrenze $U_{min}$ (die Kondensator- bzw. Überwachungsspannung Uc steigt gegenüber dem Normalzustand zu langsam an) oder größer als die obere Toleranzgrenze $U_{max}$ (die Kondensator- bzw. Überwachungsspannung Uc steigt gegenüber dem Normalzustand zu schnell an), wird der Fehlerfall 1 erfasst.

Fig. 2B bezieht sich in ihrem linksseitigen Teil auf einen Fehlerfall 2, in dem die Aufladezeit t_Lade zu kurz ist, und in ihrem rechtsseitigen Teil auf einen Fehlerfall 3, in dem die Aufladezeit t_Lade zu lang ist. Aufgrund der zu kurzen Aufladezeit bis zum Abtastzeitpunkt erreicht die Überwachungsspannung Uc das Toleranzband nicht, und wird der Fehlerfall 2 erfasst. Aufgrund der zu langen Aufladezeit bis zum Abtastzeitpunkt überschreitet die Überwachungsspannung Uc das Toleranzband, und wird der Fehlerfall 3 erfasst.

Die Zeit, wie lange nach dem Abtastpunkt der Kondensator C1 noch weiter aufladen kann oder soll, und die Zeit, für die der Kondensator C1 dann entladen bleibt, kann beliebig gewählt werden und geht nicht in die Spannungsmessung ein. Während der Zeitspanne der weiteren Aufladung des Kondensators C1 nach dem Abtastpunkt entlädt zu einem wählbaren Zeitpunkt der Mikrocontroller μC durch Zuschalten des Transistors T1 den Kondensator C1 vollständig. Nach der vollständigen Entladung des Kondensators C1 beginnt der Mikrocontroller μC durch Sperren des Transistors T1 zu einem Zeitpunkt t0 mit einem erneuten Aufladen des Kondensators C1 aus dessen vollständig entladenem Zustand.

Wie in Fig. 2A und 2B dargestellt, geht aufgrund der strengen gegenseitigen Abhängigkeit der Ladezeit bzw. Aufladezeit t_Lade und des Werts der Überwachungsspannung Uc die absolute Ladezeit direkt in das Ergebnis mit ein. Ändert sich also die Aufladezeit t_Lade durch beispielsweise ein abweichendes Timing oder eine Fehlfunktion innerhalb des Mikrocontrollers μC, ändert sich die Spannung Uc proportional dazu und kann schließlich das Toleranzband verlassen. Dadurch können derartige Fehler im Mikrocontroller μC eindeutig erkannt und daraufhin das Gesamtsystem in einen sicherheitsunkritischen Betriebszustand gebracht werden.

In einer Modifikation kann optional der absolute Wert der Referenzspannung $U_{Ref}$ ermittelt werden, indem der Mikrocontroller μC testweise den Transistor T1 so lange sperrt, bis sich der Kondensator C1 vollständig auf die Referenzspannung $U_{Ref}$ aufgeladen hat (in diesem Ausführungsbeispiel beispielsweise nach einer Zeit t = 5*R1*C1). Dadurch ist es beispielsweise möglich, alle vorhandenen Analog-Digital-Wandlerkanäle des Mikrocontrollers μC mit Hilfe der Referenzspannung zu kalibrieren und die Erfassungsgenauigkeit des Analog-Digital-Wandlers weiter zu steigern.

In einer weiteren Modifikation kann der Mikrocontroller μC durch mehrfaches Abtasten der Ladekurve des Kondensators C1 zu definierten Abtastzeiten auch eine Fehlerunterscheidung durchführen. Beispielsweise kann dann, wenn aufgrund etwa eines Kurzschlusses und/oder Nebenschlusses auf ein anderes Potenzial einer Leiterplatte zwei aufeinander folgende Abtastungen der Überwachungsspannung Uc einen konstanten Wert liefern, erfasst werden, dass die Aufladung des Kondensators C1 gestört sein muss. Es wird angemerkt, dass die Erfindung nicht auf die vorstehenden Modifikationen beschränkt ist, sondern eine Diagnosetiefe nahezu beliebig erstreckt und/oder verbessert werden kann.

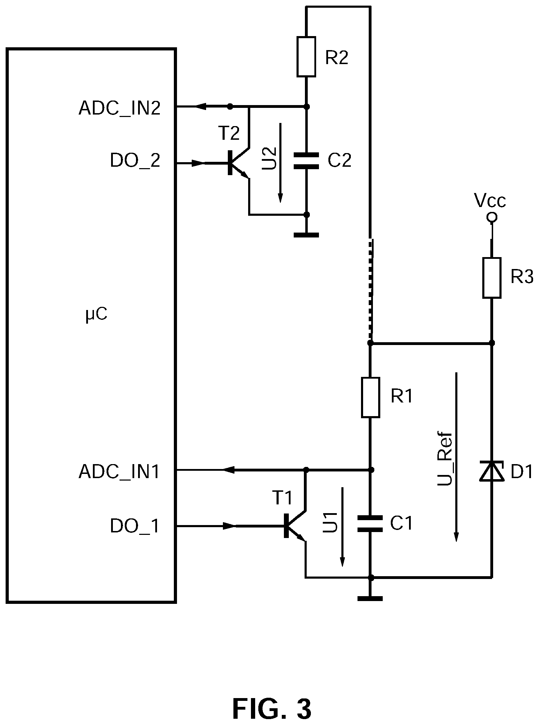

**Fig. 3** zeigt eine vereinfachte, ausschnittsweise Prinzipdarstellung einer Wächter-Schaltungsanordnung zur Überwachung des zeitlichen Verhaltens oder Timingverhaltens eines Mikrocontrollers gemäß einem ersten Ausführungsbeispiel.

Die in Fig. 3 dargestellte Schaltungsanordnung ist gegenüber der in Fig. 1 gezeigten Konfiguration durch eine Verdoppelung von Schaltungsteilen verbessert, und beinhaltet daher einen (mehrkanaligen) Mikrocontroller μC an sich bekannter Art mit, neben üblicherweise vorhandenen Ein- und Ausgängen bzw. Ports, zumindest einem ersten Analog-Digital-Wandlereingang ADC_IN1, einem zweiten Analog-Digital-Wandlereingang ADC_IN2, einem ersten digitalen Ausgang bzw. Digitalausgang DO_1 und einem zweiten digitalen Ausgang bzw. Digitalausgang DO_2.

In Fig. 3 rechtsseitig sind ein erster und ein zweiter Wächterspannungserzeugungsabschnitt dargestellt, die zumindest mit dem ersten Analog-Digital-Wandlereingang ADC_IN1 und dem ersten Ausgang DO_1 bzw. dem zweiten Analog-Digital-Wandlereingang ADC_IN2 und dem zweiten Ausgang DO_2 verbunden sind und zumindest einen ersten Transistor T1 bzw. einen zweiten Transistor T2, einen ersten Kondensator C1 bzw. einen zweiten Kondensator C2, einen ersten ersten Widerstand R1 bzw. einen zweiten ersten Widerstand R2, eine Diode D1 und einen Widerstand R3 beinhalten.

Grundlegend sind damit der erste und der zweite Wächterspannungserzeugungsabschnitt gleichartig bzw. identisch aufgebaut. Im Einzelnen ist nach Fig. 3 ein erster Anschluss des Transistors T1, beispielsweise der Drain- oder Kollektor-Anschluss, mit dem ersten Eingang ADC_IN1 des Mikrocontrollers μC verbunden, und ist ein zweiter Anschluss des Transistors T1, beispielsweise der Gate- oder Basisanschluss, mit dem Digitalausgang DO_1 verbunden. Ferner ist der erste Anschluss des Transistors T1 mit einem zweiten Ende des ersten ersten Widerstands R1 und einem ersten Anschluss des ersten Kondensators C1 verbunden. Ein zweites Ende des ersten ersten Widerstands R1 liegt an einer Referenzspannung $U_{Ref}$, die über die Diode D1, beispielsweise eine geeignete Zenerdiode, bereitgestellt wird. Die Diode D1 liegt dazu parallel zu der Reihenschaltung aus dem ersten ersten Widerstand R1 und dem ersten Kondensator C1 und wird von dem Widerstand R3 aus einer Versorgungsspannung Vcc von beispielsweise 5V einer elektronischen Steuereinheit (ECU), in der sowohl der Mikrocontroller μC als auch die Wächterspannungserzeugungsabschnitte angeordnet bzw. integriert sind, versorgt. Ein dritter Anschluss des ersten Transistors T1 (Source- oder Emitter), ein zweiter Anschluss des ersten Kondensators C1 und die Anodenseite der Diode D1 liegen an einem gemeinsamen Knoten auf einem Massepotenzial. Außerdem ist ein erster Anschluss des zweiten Transistors T2, beispielsweise der Drain- oder Kollektor-Anschluss, mit dem zweiten Eingang ADC_IN2 des Mikrocontrollers μC verbunden, und ist ein zweiter Anschluss des zweiten Transistors T2, beispielsweise der Gate- oder Basisanschluss, mit dem zweiten Digitalausgang DO_2 des Mikrocontroller μCs verbunden. Ferner ist der erste Anschluss des zweiten Transistors T2 mit einem zweiten Ende des zweiten ersten Widerstands R2 und einem ersten Anschluss des zweiten Kondensators C2 verbunden.

Ein zweites Ende des zweiten ersten Widerstands R2 liegt an einer Referenzspannung $U_{Ref}$, die über die Diode D1, beispielsweise eine geeignete Zenerdiode, bereitgestellt wird, an. Zur Bereitstellung der Referenzspannung $U_{Ref}$ liegt die Diode D1 parallel zu der Reihenschaltung aus dem zweiten ersten Widerstand R2 und dem zweiten Kondensator C2 und wird von dem Widerstand R3 aus der Versorgungsspannung Vcc von beispielsweise 5V der elektronischen Steuereinheit (ECU), in der sowohl der Mikrocontroller μC als auch die Wächterspannungserzeugungsabschnitte angeordnet bzw. integriert sind, versorgt. Ein dritter Anschluss des zweiten Transistors T2 (Source- oder Emitter), ein zweiter Anschluss des zweiten Kondensators C2 und die Anodenseite der Diode D1 können an einem gemeinsamen Knoten auf einem Massepotenzial liegen.

Auch hier können die vorstehend beschriebenen Transistoren T1 und/oder T2, die in der beschriebenen Konfiguration als Entladetransistoren für den Kondensator C1 bzw. C2 arbeiten, in einer Modifikation des vorliegenden Ausführungsbeispiels und als Variante eines Mikrocontrollerports auch bereits im Mikrocontroller μC integriert sein. In diesem Fall können die Kondensatoren C1 und/oder C2 direkt mit den entsprechenden Eingangs- und Ausgangsports des Mikrocontrollers μC verbunden sein.

Außerdem besteht keine Beschränkung im Hinblick auf ein zugrundeliegendes Bezugspotenzial. Obwohl wie vorstehend beschrieben und in Fig. 1 und Fig. 3 gezeigt ein Massepotenzial bzw. GND (Ground) ein solches Bezugspotenzial bilden kann, kann das Bezugspotenzial in Übereinstimmung mit bzw. passend zu einem Erfassungsbereich des Analog-Digital-Wandler-Eingangs des Mikrocontrollers μC beliebig gewählt werden, Beispielsweise kann gegenüber der in Fig. 1 und Fig. 3 gezeigten Konfiguration zumindest einer der Transistoren T1, T2 invertiert angeordnet sein, und kann in diesem Fall anstelle des Massepotenzials auch die Versorgungsspannung Vcc als Bezugspotenzial verwendet werden.

In der vorgenannten Anordnung liegt damit der erste Transistor T1, der in dieser Konfiguration einen Entladetransistor für den ersten Kondensator C1 bildet, parallel zu dem ersten Kondensator C1, und liegt die Reihenschaltung aus dem ersten ersten Widerstand R1 und dem ersten Kondensator C1, die in dieser Konfiguration ein RC-Glied R1/C1 bildet, parallel zu der Diode D1. Außerdem liegt der zweite Transistor T2, der in dieser Konfiguration einen Entladetransistor für den zweiten Kondensator C2 bildet, parallel zu dem zweiten Kondensator C2, und liegt die Reihenschaltung aus dem zweiten ersten Widerstand R2 und dem zweiten Kondensator C2, die in dieser Konfiguration ein RC-Glied R2/C2 bildet, parallel zu der Diode D1.

In dieser Konfiguration sind somit als Verbesserung gegenüber dem in Fig. 1 gezeigten Beispiel durch eine Verdoppelung von Schaltungsteilen und/oder Beschaltungen mehrere redundante Kanäle ausgebildet, auf die jeweils die vorstehend unter Bezugnahme auf Fig. 1 beschriebenen Spannungserzeugungs-, Lade- und Entladeverhältnisse, Ansteuerungen von Bauelementen und Toleranzbetrachtungen anwendbar sind. Zur Vermeidung von Redundanz der Beschreibung werden diese daher nicht nochmals beschrieben.

Gegenüber dem Beispiel nach Fig. 1 werden in dem ersten Ausführungsbeispiel beide Wächterspannungserzeugungsabschnitte bevorzugt phasenverschoben bzw. zeitlich verschoben derart abgetastet und angesteuert, dass ein erster Pin des Mikrocontrollers $\mu$C die Spannung an dem Kondensator C1 nach beispielsweise einer Zeit t1 abtastet, während ein zweiter Pin des Mikrocontrollers $\mu$C die Spannung an dem Kondensator C2 nach einer Zeit t2 = t1 + $\Delta$t bzw. t_delta abtastet. Hierbei kann der Abtastwert nach t2 beispielsweise nach 70% der Zeit t_Lade und mit ausreichendem zeitlichen Abstand zu t1 gewählt werden.

In einer Modifikation sind gleichzeitig oder alternativ die Zeitkonstanten der Zeitglieder R1/C1 und R2/C2 unterschiedlich ausgelegt (R1*C1 $\neq$ R2*C2). Dadurch ist es möglich, asymmetrische Störungen wie Gleichtaktstörungen bzw. Common-Mode-Störungen , besser zu unterscheiden.

Gemäß dem zweiten Ausführungsbeispiel ist vorteilhaft eine weiter gehende Erkennung von Einzelfehlern an der Wächter-Schaltungsanordnung möglich. Beispielsweise kann der Mikrocontroller $\mu$C sporadische Taktaussetzer oder einen defekten Ansteuerport DO_1 für den Entladetransistor T1 zeigen. Dadurch bliebe in diesem Fall der erste Kondensator C1 entladen. Dies würde nicht korrekt erfasst werden können, wenn ein einkanalig ausgelegter Mikrocontroller $\mu$C in diesem Zustand weiterarbeiten würde. Da sich bei mehrkanaliger Auslegung jedoch der zweite Kondensator C2 dennoch weiter auflädt und damit außerhalb des Toleranzbands gerät, ist ein Fehler der vorgenannten Art durch Auswertung auch des zweiten Kanals erkennbar.

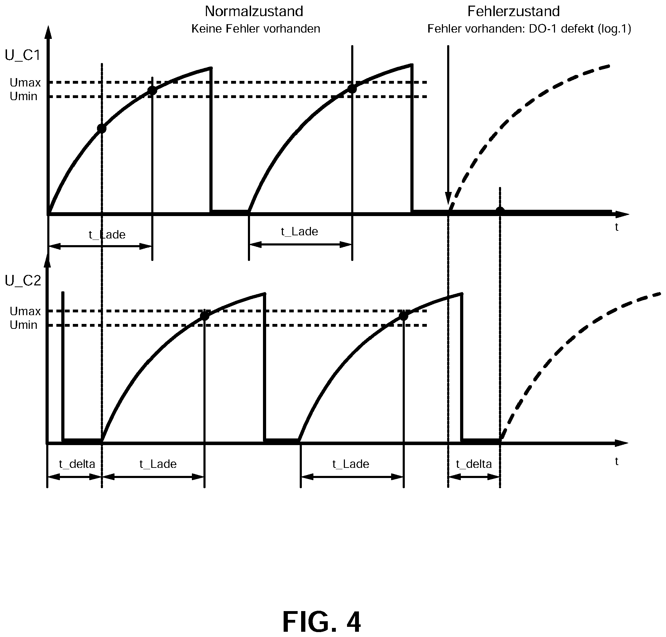

Fig. 4 zeigt ausschnittsweise typische Signalverläufe in Form von Spannungsverläufen U_C1, U_C2, insbesondere in einem Fehlerfall mit redundanten Kanälen, bei verschiedenen Betriebszuständen in der Wächter-Schaltungsanordnung nach Fig. 3. Speziell sind in Fig. 4 der vorgenannte Fehlerzustand eines defekten (beispielsweise dauerhaft auf logisch 1 liegenden) Ausgangs DO_1 des Mikrocontrollers $\mu$C und die um t_delta zeitlich verschobene Abtastung der einzelnen, mit dem ersten und dem zweiten Wächterspannungserzeugungsabschnitt konfigurierten Kanäle dargestellt. Im Übrigen entspricht, wie der Zeichnung ohne Weiteres entnehmbar ist, die Betrachtungsweise der Fig. 4 derjenigen der Fig. 2A und/oder 2B, und wird insoweit zur Vermeidung redundanten Inhalts der Beschreibung nicht nochmals beschrieben.

BEZUGSZEICHENLISTE

| $\mu$C | Mikrocontroller |
|---|---|
| C1 | erster Kondensator |
| C2 | zweiter Kondensator |
| T1 | erster Transistor |
| T2 | zweiter Transistor |
| R1 | erster/ erster erster Widerstand |
| R2 | zweiter erster Widerstand |
| R3 | zweiter Widerstand bzw. Versorgungswiderstand |
| D1 | Diode |
| Vcc | Versorgungsspannung |
| $U_{Ref}$ | Referenzspannung |
| Uc, U_C1, U_C2 | Überwachungsspannungen |

**Patentansprüche**

1. Schaltungsanordnung zur Überwachung des Timingverhaltens eines Mikrocontrollers, beinhaltend

- einen Mikrocontroller ($\mu$C), der dazu angeordnet ist, zumindest einen Wächterspannungserzeugungsabschnitt (T1, C1, R1, R3, D1; T1, T2, C1, C2, R1, R2, R3, D1) zur zeitlich definierten Erzeugung zumindest einer Überwachungsspannung (Uc; U1, U2) anzusteuern und zu einem vorbestimmten Abtastzeitpunkt die dann erzeugte Überwachungsspannung (Uc; U1, U2) zu erfassen und einzulesen; und
- den zumindest einen Wächterspannungserzeugungsabschnitt (T1, C1, R1, R3, D1; T1, T2, C1, C2, R1, R2, R3, D1), der dazu angeordnet ist, die zu einem vorbestimmten Abtastzeitpunkt durch Abtastung durch den Mikrocontroller erfassbare Überwachungsspannung (Uc; U1, U2) zu erzeugen, wobei eine zu dem Abtastzeitpunkt erfasste, innerhalb eines vorbestimmten Spannungstoleranzbereichs liegende Überwachungsspannung (Uc; U1, U2) einen fehlerfreien Zustand des Mikrocontrollers ($\mu$C) anzeigt, und eine zu dem vorbestimmten Zeitpunkt erfasste, außerhalb des vorbestimmten Spannungstoleranzbereichs liegende Überwachungsspannung (Uc; U1, U2) einen fehlerhaften Zustand des Mikrocontrollers ($\mu$C) anzeigt, wobei

a) der Wächterspannungserzeugungsabschnitt (T1, C1, R1, R3, D1; T1, T2, C1, C2, R1, R2, R3, D1) zumindest einen Kondensator (C1; C1, C2) aufweist, an dem die Überwachungsspannung (Uc; U1, U2) bereitgestellt wird, und wobei

b) der Wächterspannungserzeugungsabschnitt (T1, C1, R1, R3, D1; T1, T2, C1, C2, R1, R2, R3, D1) zumindest einen elektronischen Schalter (T1; T1, T2) aufweist, der parallel zu dem Kondensator (C1; C1, C2) verschaltet und in Abhängigkeit von einem logischen Zustand an einem Ausgang (DO; DO_1, DO_2) des Mikrocontrollers ($\mu$C) durch den Mikrocontroller ($\mu$C) zeitgesteuert schaltbar ist, wobei während eines Zustands von logisch 0 des Ausgangs (DO; DO_1, DO_2) der elektronische Schalter (T1; T1, T2) gesperrt wird und der Kondensator (C1; C1, C2) definiert aufladbar ist, und während eines Zustands von logisch 1 des Ausgangs (DO; DO_1, DO_2) der elektronische Schalter (T1; T1, T2) durchgeschaltet wird und der Kondensator (C1; C1, C2) definiert entladbar ist, und wobei

c) der Kondensator (C1; C1, C2) dazu angeordnet ist, gesteuert durch den Mikrocontroller ($\mu$C) über den elektronischen Schalter (T1; T1, T2) zu einem beliebigen Zeitpunkt vollständig entladen zu werden, und aus dem entladenen Zustand zu einem vorbestimmten Zeitpunkt (t0) geladen zu werden, wobei die Kondensatorspannung und zu einem nachfolgenden Abtastzeitpunkt die Überwachungsspannung (Uc; U1, U2) an dem Kondensator (C1; C1, C2) gemäß der eine Ladekurve definierenden Gleichung

$$U(c/1/2) = U_{Ref} * (1 - exp(-t_{lade}/R*C)$$

entstehen, worin Uc oder U1 und/oder U2 die Überwachungsspannung ist, die der Mikrocontroller ($\mu$C) nach einer bekannten Aufladezeit ab dem vorbestimmten Zeitpunkt (t0) zu dem Abtastzeitpunkt einlesen wird, $U_{Ref}$ eine hochstabile Referenzspannung ist, deren Wert genau bekannt ist, $t_{lade}$ die bekannte Aufladezeit ist, und R/C ein RC-Glied aus einem Widerstand und dem Kondensator definiert, welches eine Zeitkonstante $\tau$ = R*C festlegt, mit welcher sich der Kondensator (C1; C1, C2) auflädt, und wobei

d) ein erster Wächterspannungserzeugungsabschnitt (T1, C1, R1, R3) vorgesehen ist, bei dem

- ein erster erster Widerstand (R1) in Reihe mit einem ersten Kondensator (C1) verschaltet ist und an einem ersten seiner Enden an einer Referenzspannung ($U_{Ref}$) liegt und an einem zweiten seiner Enden mit einem ersten Anschluss des ersten Kondensators (C1) verbunden ist;
- ein Versorgungswiderstand (R3) vorgesehen ist, der an einem ersten seiner Enden an einer Versorgungsspannung liegt und an einem zweiten seiner Enden kathodenseitig mit einer Diode (D1) verbunden ist, die die Referenzspannung ($U_{Ref}$) zwischen dem ersten Ende des ersten ersten Widerstands (R1) und einem zweiten Anschluss des ersten Kondensators (C1) bereitstellt; und
- ein erster elektronischer Schalter (T1) einen ersten Anschluss, der mit dem ersten Anschluss des ersten Kondensators (C1) und einem ersten Analogwandlereingang (ADC_IN1) des Mikrocontrollers ($\mu$C) verbunden ist, einen zweiten Anschluss, der mit einem ersten Ausgang (DO_1) des Mikrocontrollers ($\mu$C) verbunden ist, und einen dritten Anschluss, der mit dem zweiten Anschluss des ersten Kondensators (C1), anodenseitig mit der Diode (D1) und einem Bezugspotenzial verbunden ist, aufweist, und ein zweiter Wächterspannungserzeugungsabschnitt ( T2, C2, R2, R3, D1) vorgesehen ist, bei dem
- ein zweiter erster Widerstand (R2) in Reihe mit einem zweiten Kondensator (C2) verschaltet ist und an einem ersten seiner Enden an einer Referenzspannung ($U_{Ref}$) liegt und an einem zweiten seiner Enden mit einem ersten Anschluss des zweiten Kondensators (C2) verbunden ist;
- der Versorgungswiderstand (R3) die Referenzspannung ($U_{Ref}$) zwischen dem ersten Ende des zweiten ersten Widerstands (R2) und einem zweiten Anschluss des zweiten Kondensators (C2) bereitstellt; und
- ein zweiter elektronischer Schalter (T2) einen ersten Anschluss, der mit dem ersten Anschluss des zweiten Kondensators (C2) und einem zweiten Analogwandlereingang (ADC_IN2) des Mikrocontrollers ($\mu$C) verbunden ist, einen zweiten Anschluss, der mit einem zweiten Ausgang (DO_2) des Mikrocontrollers ($\mu$C) verbunden ist, und einen dritten Anschluss, der mit dem zweiten Anschluss des zweiten Kondensators (C2) und einem Bezugspotenzial verbunden ist, aufweist, wobei
- der erste Wächterspannungserzeugungsabschnitt (T1, C1, R1, R3) und der zweite Wächterspannungserzeugungsabschnitt (T2, C2, R2, R3, D1) eine mehrkanalige Wächter-Schaltungsanordnung ausbilden.

**2.** Schaltungsanordnung nach Anspruch 1, **dadurch gekennzeichnet, dass** der erste Wächterspannungserzeugungsabschnitt (T1, C1, R1, R3) und der zweite Wächterspannungserzeugungsabschnitt derart phasenverschoben angesteuert und abgetastet werden, dass eine der Überwachungsspannungen (U1) an einem der Kondensatoren (C1) zu einer ersten vorbestimmten Zeit (t1) erfasst und von dem Mikrocontroller ($\mu$C) eingelesen wird, und eine andere der Überwachungsspannungen (U2) an einem anderen der Kondensatoren (C2) zu einer zweiten vorbestimmten Zeit (t2 = t1 + $\Delta$t) erfasst und von dem Mikrocontroller ($\mu$C) eingelesen wird.

**3.** Schaltungsanordnung nach einem der vorhergehenden Ansprüche, **dadurch gekennzeichnet, dass** sich die Zeitkonstante des durch den ersten ersten Widerstand (R1) und den ersten Kondensator (C1) bestimmten Zeitglieds und die Zeitkonstante des durch den zweiten ersten Widerstand (R2) und den zweiten Kondensator (C2) bestimmten Zeitglieds voneinander unterscheiden.

**4.** Schaltungsanordnung nach einem der vorangehenden Ansprüche, **dadurch gekennzeichnet, dass** Abtastungen der Ladekurve des Kondensators (C1; C1, C2) zu definierten Abtastzeiten zyklisch wiederholt werden.

**5.** Schaltungsanordnung nach einem der vorangehenden Ansprüche, **dadurch gekennzeichnet, dass** der Mikrocon-troller ($\mu$C) dazu angeordnet ist, den elektronischen Schalter (T1; T1, T2) bis zur vollständigen Aufladung des Kondensators (C1; C1, C2) zu sperren, danach den absoluten Wert der Referenzspannung ($U_{Ref}$) zu erfassen, und auf der Grundlage des erfassten Werts der Referenzspannung ($U_{Ref}$) zumindest einen Analog-Digital-Wandlerkanal des Mikrocontrollers ($\mu$C) zu kalibrieren.

**6.** Schaltungsanordnung nach einem der i vorhergehenden Ansprüche, **dadurch gekennzeichnet, dass** der elektronische Schalter (T1; T1, T2) als ein Transistor ausgebildet ist.

**7.** Schaltungsanordnung nach einem der vorhergehenden Ansprüche, **dadurch gekennzeichnet, dass** der elektronische Schalter in den Mikrocontroller ($\mu$c) integriert ausgebildet ist.

**8.** Schaltungsanordnung nach einem der Ansprüche 1 bis 6, **dadurch gekennzeichnet, dass** der elektronische Schal-ter außerhalb des Mikrocontrollers ($\mu$C) liegend vorgesehen und mit diesem verbunden ist.

**9.** Verfahren zur Überwachung eines Mikrocontrollers auf der Grundlage einer Wächterspannung zur Überwachung des Timingverhaltens eines Mikrocontrollers, die in einer Wächter-Schaltungsanordnung nach einem der vorangehenden Ansprüche erzeugt wird, **gekennzeichnet durch** die Schritte:

- Ansteuern zumindest eines Wächterspannungserzeugungsabschnitts (T1, C1, R1, R3, D1; T1, T2, C1, C2, R1, R2, R3, D1) zur zeitlich definierten Erzeugung zumindest einer Überwachungsspannung (Uc; U1, U2), wobei das Ansteuern ein definiertes Entladen eines Kondensators (C1; C1, C2) und sodann, beginnend zu einem vorbestimmten Zeitpunkt (t0; t1, t2), definiertes Laden des Kondensators (C1; C1, C2) entlang einer Ladekurve beinhaltet; und
- Erfassen und Einlesen der zu einem vorbestimmten Abtastzeitpunkt erzeugten Ladespannung des Kondensators (C1; C2, C2) als die Überwachungsspannung (Uc; U1, U2), wobei
- eine zu dem Abtastzeitpunkt erfasste, innerhalb eines vorbestimmten Spannungstoleranzbereichs liegende Überwachungsspannung (Uc; U1, U2) einen fehlerfreien Zustand des Mikrocontrollers ($\mu$C) anzeigt, und eine zu dem vorbestimmten Zeitpunkt erfasste, außerhalb des vorbestimmten Spannungstoleranzbereichs liegende Überwachungsspannung (Uc; U1, U2) einen fehlerhaften Zustand des Mikrocontrollers ($\mu$C) anzeigt, wobei
- der erste Wächterspannungserzeugungsabschnitt (T1, C1, R1, R3) und der zweite Wächterspannungserzeugungsabschnitt derart phasenverschoben angesteuert und abgetastet werden, dass eine der Überwachungsspannungen (U1) an einem der Kondensatoren (C1) zu einer ersten vorbestimmten Zeit (t1) erfasst und von dem Mikrocontroller ($\mu$C) eingelesen wird, und eine andere der Überwachungsspannungen (U2) an einem anderen der Kondensatoren (C2) zu einer zweiten vorbestimmten Zeit (t2 = t1 + $\Delta$t) erfasst und von dem Mikrocontroller ($\mu$C) eingelesen wird, oder wobei
- sich eine Zeitkonstante des RC-Zeitglieds des ersten Wächterspannungserzeugungsabschnitts (T1, C1, R1, R3) und eine Zeitkonstante des RC-Zeitglieds des zweiten Wächterspannungserzeugungsabschnitts voneinander Unterscheiden.

**10.** Verfahren nach Anspruch 9, **dadurch gekennzeichnet, dass** während eines Zustands von logisch 0 eines Ausgangs (DO; DO_1, DO_2) des Mikrocontrollers ein elektronischer Schalter (T1; T1, T2) gesperrt wird und der Kondensator (C1; C1, C2) definiert aufladbar ist, und während eines Zustands von logisch 1 des Ausgangs (DO; DO_1, DO_2) der elektronische Schalter (T1; T1, T2) durchgeschaltet wird und der Kondensator (C1; C1, C2) definiert entladbar ist.

11. Verfahren nach Anspruch 10, **dadurch gekennzeichnet, dass** der Kondensator (C1; C1, C2) gesteuert durch den Mikrocontroller ($\mu$C) über den elektronischen Schalter (T1; T1, T2) zu einem beliebigen Zeitpunkt vollständig entladen wird, und aus dem entladenen Zustand zu einem vorbestimmten Zeitpunkt (t0) geladen wird, wobei die Kondensatorspannung und zu einem nachfolgenden Abtastzeitpunkt die Überwachungsspannung (Uc; U1, U2) an dem Kondensator (C1; C1, C2) gemäß der eine Ladekurve definierenden Gleichung

$$U(c/1/2) = U_{Ref} * (1 - \exp(-t_{lade}/R*C)$$

entstehen, worin Uc oder U1 und/oder U2 die Überwachungsspannung ist, die der Mikrocontroller ($\mu$C) nach einer bekannten Aufladezeit ab dem vorbestimmten Zeitpunkt (t0) zu dem Abtastzeitpunkt einlesen wird, $U_{Ref}$ eine hochstabile Referenzspannung ist, deren Wert genau bekannt ist, $t_{lade}$ die bekannte Aufladezeit ist, und R/C ein RC-Glied aus einem Widerstand und dem Kondensator definiert, welches eine Zeitkonstante $\tau$ = R*C festlegt, mit welcher sich der Kondensator (C1; C1, C2) auflädt.

12. Verfahren nach einem der Ansprüche 9 bis 11, **dadurch gekennzeichnet, dass** Abtastungen der Ladekurve des Kondensators (C1; C1, C2) zu definierten Abtastzeiten zyklisch wiederholt werden.

13. Verfahren nach einem der Ansprüche 9 bis 12, **dadurch gekennzeichnet, dass** der elektronische Schalter (T1; T1, T2) bis zur vollständigen Aufladung des Kondensators (C1; C1, C2) gesperrt wird, danach der absolute Wert der Referenzspannung ($U_{Ref}$) erfasst wird, und auf der Grundlage des erfassten Werts der Referenzspannung ($U_{Ref}$) zumindest ein Analog-Digital-Wandlerkanal des Mikrocontrollers ($\mu$C) kalibriert wird.

## Claims

1. Circuit assembly for monitoring the timing behavior of a microcontroller, comprising

    - a microcontroller ($\mu$C) arranged to drive at least one watchdog voltage generating section (T1, C1, R1, R3, D1; T1, T2, C1, C2, R1, R2, R3, D1) for the temporally defined generation of at least one monitoring voltage (Uc; U1, U2) and to detect and read in the then generated monitoring voltage (Uc; U1, U2) at a predetermined sampling point in time; and
    - the at least one watchdog voltage generating section (T1, C1, R1, R3, D1; T1, T2, C1, C2, R1, R2, R3, D1) arranged to generate the monitoring voltage (Uc; U1, U2) that is detectable at a predetermined sampling point in time by sampling by the microcontroller, wherein a monitoring voltage (Uc; U1, U2) that is detected at the sampling point in time and lies within a predetermined voltage tolerance range indicates a fault-free state of the microcontroller ($\mu$C), and a monitoring voltage (Uc; U1, U2) that is detected at the predetermined point in time and lies outside the predetermined voltage tolerance range indicates a faulty state of the microcontroller ($\mu$C), wherein

        a) the watchdog voltage generating section (T1, C1, R1, R3, D1; T1, T2, C1, C2, R1, R2, R3, D1) comprises at least one capacitor (C1; C1, C2), at which the monitoring voltage (Uc; U1, U2) is provided, and wherein
        b) the watchdog voltage generating section (T1, C1, R1, R3, D1; T1, T2, C1, C2, R1, R2, R3, D1) comprises at least one electronic switch (T1; T1, T2), which is interconnected in parallel with the capacitor (C1; C1, C2) and is switchable in a time-controlled manner by the microcontroller ($\mu$C) depending on a logic state at an output (DO; DO_1, DO_2) of the microcontroller ($\mu$C), wherein, during a state of logic 0 of the output (DO; DO_1, DO_2), the electronic switch (T1; T1, T2) is turned off and the capacitor (C1; C1, C2) is chargeable in a defined manner, and, during a state of logic 1 of the output (DO; DO_1, DO_2), the electronic switch (T1; T1, T2) is turned on and the capacitor (C1; C1, C2) is dischargeable in a defined manner, and wherein
        c) the capacitor (C1; C1, C2) is arranged to be completely discharged at an arbitrary point in time, and to be charged from the discharged state at a predetermined point in time (t0), via the electronic switch (T1; T1, T2) in a manner controlled by the microcontroller ($\mu$C), wherein the capacitor voltage and, at a subsequent sampling point in time, the monitoring voltage (Uc; U1, U2) arise at the capacitor (C1; C1, C2) in accordance with the following equation defining a charging curve:

$$U(c/1/2) = U_{Ref} * (1 - \exp(-t_{charge}/R*C)$$

wherein Uc or U1 and/or U2 is the monitoring voltage that the microcontroller ($\mu$C) will read in at the sampling point in time after a known charging time starting from the predetermined point in time (t0), $U_{Ref}$ is a highly stable reference voltage, the value of which is known precisely, $t_{charge}$ is the known charging time, and R/C defines an RC element comprising a resistor and the capacitor, which RC element defines a time constant $\tau$ = R*C with which the capacitor (C1; C1, C2) is charged, and wherein
d) a first watchdog voltage generating section (T1, C1, R1, R3) is provided, in which

- a first first resistor (R1) is interconnected in series with a first capacitor (C1) and is connected to a reference voltage ($U_{Ref}$) at a first of its ends and is connected to a first terminal of the first capacitor (C1) at a second of its ends;
- a supply resistor (R3) is provided, which is connected to a supply voltage at a first of its ends and is connected to a diode (D1) cathodally at a second of its ends, which diode provides the reference voltage ($U_{Ref}$) between the first end of the first first resistor (R1) and a second terminal of the first capacitor (CI); and
- a first electronic switch (T1) comprises a first terminal, which is connected to the first terminal of the first capacitor (C1) and a first analog converter input (ADC_IN1) of the microcontroller ($\mu$C), a second terminal, which is connected to a first output (DO_1) of the microcontroller ($\mu$C), and a third terminal, which is connected to the second terminal of the first capacitor (C1), anodally to the diode (D1) and to a reference potential, and

a second watchdog voltage generating section (T2, C2, R2, R3, D1) is provided, in which

- a second first resistor (R2) is interconnected in series with a second capacitor (C2) and is connected to a reference voltage ($U_{Ref}$) at a first of its ends and is connected to a first terminal of the second capacitor (C2) at a second of its ends;
- the supply resistor (R3) provides the reference voltage ($U_{Ref}$) between the first end of the second first resistor (R2) and a second terminal of the second capacitor (C2); and
- a second electronic switch (T2) comprises a first terminal, which is connected to the first terminal of the second capacitor (C2) and a second analog converter input (ADC_IN2) of the microcontroller ($\mu$C), a second terminal, which is connected to a second output (DO_2) of the microcontroller ($\mu$C), and a third terminal, which is connected to the second terminal of the second capacitor (C2) and to a reference potential, wherein

the first watchdog voltage generating section (T1, C1, R1, R3) and the second watchdog voltage generating section (T2, C2, R2, R3, D1) form a multichannel watchdog circuit assembly.

2. Circuit assembly according to Claim 1, **characterized in that** the first watchdog voltage generating section (T1, C1, R1, R3) and the second watchdog voltage generating section are driven and sampled in a phase-shifted manner such that one of the monitoring voltages (U1) is detected at one of the capacitors (C1) at a first predetermined time (t1) and is read in by the microcontroller ($\mu$C), and another of the monitoring voltages (U2) is detected at another of the capacitors (C2) at a second predetermined time (t2 = t1 + $\Delta$t) and is read in by the microcontroller ($\mu$C).

3. Circuit assembly according to either of the preceding claims, **characterized in that** the time constant of the timer determined by the first first resistor (R1) and the first capacitor (C1) and the time constant of the timer determined by the second first resistor (R2) and the second capacitor (C2) differ from one another.

4. Circuit assembly according to any of the preceding claims, **characterized in that** samplings of the charging curve of the capacitor (C1; C1, C2) are repeated cyclically at defined sampling times.

5. Circuit assembly according to any of the preceding claims, **characterized in that** the microcontroller ($\mu$C) is arranged to turn off the electronic switch (T1; T1, T2) until the complete charging of the capacitor (C1; C1, C2), then to detect the absolute value of the reference voltage ($U_{Ref}$), and to calibrate at least one analog-to-digital converter channel of the microcontroller ($\mu$C) on the basis of the detected value of the reference voltage ($U_{Ref}$).

6. Circuit assembly according to any of the preceding claims, **characterized in that** the electronic switch (T1; T1, T2) is embodied as a transistor.

7. Circuit assembly according to any of the preceding claims, **characterized in that** the electronic switch is embodied in a manner integrated into the microcontroller (μC).

8. Circuit assembly according to any of Claims 1 to 6, **characterized in that** the electronic switch is provided in a manner situated outside the microcontroller (μC) and is connected thereto.

9. Method for monitoring a microcontroller on the basis of a watchdog voltage for monitoring the timing behavior of a microcontroller, said watchdog voltage being generated in a watchdog circuit assembly according to any of the preceding claims, **characterized by** the following steps:

   - driving at least one watchdog voltage generating section (T1, C1, R1, R3, D1; T1, T2, C1, C2, R1, R2, R3, D1) for the temporally defined generation of at least one monitoring voltage (Uc; U1, U2), wherein the driving comprises a defined discharging of a capacitor (C1; C1, C2) and then, beginning at a predetermined point in time (t0; t1, t2), defined charging of the capacitor (C1; C1, C2) along a charging curve; and
   - detecting and reading in the charging voltage of the capacitor (C1; C1, C2), said charging voltage being generated at a predetermined sampling point in time, as the monitoring voltage (Uc; U1, U2), wherein
   - a monitoring voltage (Uc; U1, U2) that is detected at the sampling point in time and lies within a predetermined voltage tolerance range indicates a fault-free state of the microcontroller (μC), and a monitoring voltage (Uc; U1, U2) that is detected at the predetermined point in time and lies outside the predetermined voltage tolerance range indicates a faulty state of the microcontroller (μC), wherein
   - the first watchdog voltage generating section (T1, C1, R1, R3) and the second watchdog voltage generating section are driven and sampled in a phase-shifted manner such that one of the monitoring voltages (U1) is detected at one of the capacitors (C1) at a first predetermined time (t1) and is read in by the microcontroller (μC), and another of the monitoring voltages (U2) is detected at another of the capacitors (C2) at a second predetermined time (t2 = t1 + Δt) and is read in by the microcontroller (μC), or wherein
   - a time constant of the RC timer of the first watchdog voltage generating section (T1, C1, R1, R3) and a time constant of the RC timer of the second watchdog voltage generating section differ from one another.

10. Method according to Claim 9, **characterized in that,** during a state of logic 0 of an output (DO; DO_1, DO_2) of the microcontroller, an electronic switch (T1; T1, T2) is turned off and the capacitor (C1; C1, C2) is chargeable in a defined manner, and, during a state of logic 1 of the output (DO; DO_1, DO_2), the electronic switch (T1; T1, T2) is turned on and the capacitor (C1; C1, C2) is dischargeable in a defined manner.

11. Method according to Claim 10, **characterized in that** the capacitor (C1; C1, C2) is completely discharged at an arbitrary point in time, and is charged from the discharged state at a predetermined point in time (t0), via the electronic switch (T1; T1, T2) in a manner controlled by the microcontroller (μC), wherein the capacitor voltage and, at a subsequent sampling point in time, the monitoring voltage (Uc; U1, U2) arise at the capacitor (C1; C1, C2) in accordance with the following equation defining a charging curve:

$$U(c/1/2) = U_{Ref} * (1 - \exp(-t_{charge}/R*C)$$

wherein Uc or U1 and/or U2 is the monitoring voltage that the microcontroller (μC) will read in at the sampling point in time after a known charging time starting from the predetermined point in time (t0), $V_{Ref}$ is a highly stable reference voltage, the value of which is known precisely, $t_{charge}$ is the known charging time, and R/C defines an RC element comprising a resistor and the capacitor, which RC element defines a time constant $\tau = R*C$ with which the capacitor (C1; C1, C2) is charged.

12. Method according to any of Claims 9 to 11, **characterized in that** samplings of the charging curve of the capacitor (C1; C1, C2) are repeated cyclically at defined sampling times.

13. Method according to any of Claims 9 to 12, **characterized in that** the electronic switch (T1; T1, T2) is turned off until complete charging of the capacitor (C1; C1, C2), then the absolute value of the reference voltage ($V_{Ref}$) is detected, and at least one analog-to-digital converter channel of the microcontroller (μC) is calibrated on the basis of the detected value of the reference voltage ($U_{Ref}$).

**Revendications**

1. Montage de contrôle du comportement de timing d'une microunité de commande, comportant

- une microunité ($\mu$C) de commande, montée pour commander au moins une partie (T1, C1, R1, R3, D1 ; T1, T2, C1, C2, R1, R2, R3, D1) de production d'une tension de surveillance pour produire, d'une manière définie dans le temps, au moins une tension (Uc ; U1, U2) de surveillance et pour détecter et lire, à un instant d'échantillonnage déterminé à l'avance, la tension (Uc ; U1, U2) de surveillance produite et
- la au moins une partie (T1, C1, R1, R3, D1 ; T1, T2, C1, C2, R1, R2, R3, D1) de production d'une tension de surveillance, qui est montée pour produire la tension (Uc ; U1, U2) de surveillance pouvant être détectée par échantillonnage par la microunité de commande à un instant d'échantillonnage déterminé à l'avance, une tension (Uc, U1, U2) de surveillance détectée à l'instant d'échantillonnage et se trouvant dans une plage de tolérance de tension définie à l'avance, indiquant un état sans défaut de la microunité ($\mu$C) de commande, et une tension (Uc ; U1, U2) de surveillance, détectée à l'instant déterminé à l'avance et se trouvant à l'extérieur de la plage de tolérance de tension déterminée à l'avance, indiquant un état défectueux de la microunité ($\mu$C) de commande, dans lequel

   a) la partie (T1, C1, R1, R3, D1 ; T1, T2, C1, C2, R1, R2, R3, D1) de production d'une tension de surveillance a au moins un condensateur (C1 ; C1, C2) auquel est appliquée la tension (Uc ; U1, U2) de surveillance et dans lequel
   b) la partie (T1, C1, R1, R3, D1 ; T1, T2, C1, C2, R1, R2, R3, D1) de production d'une tension de surveillance a au moins un interrupteur (T1 ; T1, T2) électronique, qui est monté en parallèle au condensateur (C1 ; C1, C2) et qui, en fonction d'un état logique à une sortie (DO ; DO_1, DO_2) de la microunité ($\mu$C) de commande, peut être commuté de manière commandée dans le temps par la microunité ($\mu$C) de commande, dans lequel, pendant un état de 0 logique de la sortie (DO ; DO_1, DO_2), l'interrupteur (T1 ; T1, T2) électronique est bloqué et le condensateur (C1 ; C1, C2) peut être chargé de manière définie et, pendant un état de 1 logique de la sortie (DO ; DO_1, DO_2), l'interrupteur (T1 ; T1, T2) électronique est passant et le condensateur (C1 ; C1, C2) peut être déchargé de manière définie, et dans lequel
   c) le condensateur (C1 ; C1, C2) est monté de manière à ce que, commandé par la microunité ($\mu$C) de commande, par l'intermédiaire de l'interrupteur (T1 ; T1, T2) électronique, il soit déchargé complètement à un instant quelconque et de manière à être, à partir de l'état déchargé, chargé à un instant (t0) déterminé à l'avance, la tension du condensateur et, à un instant d'échantillonnage venant ensuite, la tension (Uc U1, U2) de surveillance appliquée au condensateur (C1 ; C1, C2) provenant d'une équation définissant une courbe de charge

$$U(c/1/2) = U_{Ref}*(1 - \exp(-t_{lade}/R*C)$$

dans laquelle Uc ou U1 et/ou U2 est la tension de surveillance, que la microunité ($\mu$C) de commande lit à l'instant d'échantillonnage, après un temps de charge connu à partir de l'instant (t0) déterminé à l'avance, $U_{Ref}$ est une tension de référence très stable, dont la valeur est connue exactement, $t_{lade}$ est le temps de charge connu et R/C définit un relais temporisateur RC composé d'une résistance et du condensateur, qui fixe une constante de temps $\tau$ = R*C suivant laquelle le condensateur (C1 ; C1, C2) se charge et dans lequel
   d) il est prévu une première partie (T1, C1, R1, R3) de production d'une tension de surveillance, dans laquelle

   - une première résistance (R1) est montée en série avec un premier condensateur (C1) et il s'applique, à une première de ses extrémités, une tension ($U_{Ref}$) de référence et elle est reliée, à une seconde de ses extrémités, à une première borne du premier condensateur (C1) ;
   - il est prévu une résistance (R3) d'alimentation à une première extrémité de laquelle s'applique une tension d'alimentation et qui est reliée, à une seconde de ses extrémités, du côté de la cathode, à une diode (DI), qui applique la tension ($U_{Ref}$) de référence entre la première extrémité de la première première résistance (R1) et une deuxième borne du premier condensateur (C1) et
   - un premier interrupteur (T1) électronique a une première borne, qui est reliée à la première borne du premier condensateur (C1) et a une première entrée (ADC_IN1) de convertisseur analogique de la microunité ($\mu$C) de commande, une deuxième borne, qui est reliée à une première sortie (DO_1) de la microunité ($\mu$C) de commande et une troisième borne, qui est reliée, par la deuxième borne du premier condensateur (C1) du côté de la cathode, à la diode (D1) et à un potentiel de référence, et

il est prévu une deuxième partie (T2, C2, R2, R3, D1) de production d'une tension de surveillance, dans laquelle

- une deuxième première résistance (R2) est montée en série avec un deuxième condensateur (C2) et il s'applique, à une première de ses extrémités, une tension (U$_{Ref}$) de référence et elle est reliée, à une seconde de ses extrémités, à une première borne du deuxième condensateur (C2),
- la résistance (R3) d'alimentation applique la tension (U$_{Ref}$) de référence entre la première extrémité de la deuxième première résistance (R2) et une deuxième borne du deuxième condensateur (C2) et
- un deuxième interrupteur (T2) électronique a une première borne, qui est reliée à la première borne du deuxième condensateur (C2) et à une deuxième entrée (ADC_IN2) de convertisseur analogique de la microunité (μC) de commande, une deuxième borne, qui est reliée à une deuxième sortie (DO_2) de la microunité (μC) de commande et une troisième borne, qui est reliée à la deuxième borne du deuxième condensateur (C2) et un potentiel de référence, dans lequel
- la première partie (T1, C1, R1, R3) de production d'une tension de surveillance et la deuxième partie (T2, C2, R2, R3, D1) de production d'une tension de surveillance constitue un montage de surveillance à plusieurs canaux.

2. Montage suivant la revendication 1, **caractérisé en ce que** la première partie (T1, C1, R1, R3) de production d'une tension de surveillance et la deuxième partie de production d'une tension de surveillance sont commandées et échantillonnées d'une manière déphasée, de manière à ce que l'une des tensions (U1) de surveillance soit détectée à l'un des condensateurs (C1) à un premier temps (t1) déterminé à l'avance et soit lue par la microunité (μC) de commande et qu'une autre des tensions (U2) de surveillance soit détectée à un autre des condensateurs (C2), à un deuxième temps (t2 = t1 + Δt) déterminé à l'avance, et soit lue par la microunité (μC) de commande.

3. Montage suivant l'une des revendications précédentes, **caractérisé en ce que** la constante de temps du relais temporisateur défini par la première première résistance (R1) et le premier condensateur (C1) et la constante de temps du relais temporisateur défini par la deuxième première résistance (R2) et le deuxième condensateur (C2) sont différentes l'une de l'autre.

4. Montage suivant l'une des revendications précédentes, **caractérisé en ce que** des échantillonnages de la courbe de charge du condensateur (C1 ; C1, C2) sont répétés cycliquement à des temps d'échantillonnage définis.

5. Montage suivant l'une des revendications précédentes, **caractérisé en ce que** la microunité (μC) de commande est montée de manière à bloquer l'interrupteur (T1 ; T1 ; T2) électronique jusqu'à chargement complet du condensateur (C1 ; C1, C2), à détecter ensuite la valeur absolue de la tension (U$_{Ref}$) de référence et, sur la base de la valeur détectée de la tension (U$_{Ref}$) de référence, à étalonner au moins un canal de convertisseur analogique-numérique de la microunité (μC) de commande.

6. Montage suivant l'une des revendications précédentes, **caractérisé en ce que** l'interrupteur (T1 ; T1, T2) électronique est constitué sous la forme d'un transistor.

7. Montage suivant l'une des revendications précédentes, **caractérisé en ce que** l'interrupteur électronique est constitué de manière intégrée à la microunité (μC) de commande.

8. Montage suivant l'une des revendications 1 à 6, **caractérisé en ce que** l'interrupteur électronique est prévu à l'extérieur de la microunité (μC) de commande et est relié à celle-ci.

9. Procédé de contrôle d'une microunité de commande sur la base d'une tension de surveillance pour contrôler le comportement de timing d'une microunité de commande, qui est produite dans un montage de surveillance suivant l'une des revendications précédentes, **caractérisé par** les stades :

- commande d'au moins une partie (T1, C1, R1, R3, D1 ; T1, T2, C1, C2, R1, R2, R3, D1) de production d'une tension de surveillance pour produire, d'une manière définie dans le temps, au moins une tension (Uc ; U1, U2) de surveillance, la commande comportant une décharge définie d'un condensateur (C1 ; C1, C2) et ensuite la charge, définie en commençant à un instant (t0 ; t1, t2), défini à l'avance, du condensateur (C1 ; C1, C2) suivant une courbe de charge et
- la détection et la lecture de la tension de charge produite à un instant d'échantillonnage déterminé à l'avance du condensateur (C1 ; C2, C2) comme tension (Uc ; U1, U2) de surveillance, dans lequel

- une tension (Uc ; U1, U2) de surveillance, pouvant être détectée par échantillonnage par la microunité de commande à un instant d'échantillonnage déterminé à l'avance, détectée à l'instant d'échantillonnage et se trouvant dans une plage de tolérance de tension définie à l'avance, indiquant un état sans défaut de la microunité (μC) de commande, et une tension (Uc ; U1, U2) de surveillance, détectée à l'instant déterminé à l'avance et se trouvant à l'extérieur de la plage de tolérance de tension déterminée à l'avance, indiquant un état défectueux de la microunité (μC) de commande, dans lequel

- on commande et on échantillonne, de manière déphasée la première partie (T1, C1, R1, R3) de production d'une tension de surveillance et la deuxième partie de production d'une tension de surveillance, en ce que l'une des tensions (U1) de surveillance est détectée sur l'un des condensateurs (C1) à un premier temps (t1) déterminé et est lue par la microunité (μC) de commande et en ce qu'une autre des tensions (U2) de surveillance est détectée sur un autre des condensateurs (C2) à un deuxième temps (t2 = t1 + Δt) déterminé à l'avance et est lue par la micro-unité (μC) de commande ou dans lequel

- une constante de temps du relais temporisateur RC de la première partie (T1, C1, R1, R3) de production d'une tension de surveillance et une constante de temps du relais temporisateur RC de la deuxième partie de production d'une tension de surveillance sont différentes l'une de l'autre.

10. Procédé suivant la revendication 9, **caractérisé en ce que**, pendant un état de 0 logique d'une sortie (DO ; DO_1, DO_2) de la microunité de commande, on bloque un interrupteur (T1 ; T1, T2) électronique et le condensateur (C1 ; C1, C2) peut être chargé de manière définie et, pendant un état de 1 logique de la sortie (DO ; DO_1, DO_2) de l'interrupteur (T1 ; T1, T2) électronique, on le rend passant et le condensateur (C1 ; C1, C2) peut être déchargé de manière définie.

11. Procédé suivant la revendication 10, **caractérisé en ce que** le condensateur (C1 ; C1, C2) est, commandé par la microunité (μC) de commande par l'intermédiaire de l'interrupteur (T1 ; T1, T2) électronique, déchargé complètement à un instant quelconque et, à partir de l'état déchargé, est chargé à un instant (t0) défini à l'avance, la tension du condensateur et, à un instant d'échantillonnage venant ensuite, la tension (Uc U1, U2) de surveillance appliquée au condensateur (C1 ; C1, C2) provenant d'une équation définissant une courbe de charge

$$U(c/1/2) = U_{Ref}*(1 - \exp(-t_{lade}/R*C)$$

dans laquelle Uc ou U1 et/ou U2 est la tension de surveillance, que la microunité (μC) de commande lit à l'instant d'échantillonnage, après un temps de charge connu à partir de l'instant (t0) déterminé à l'avance, $U_{Ref}$ est une tension de référence très stable, dont la valeur est connue exactement, $t_{lade}$ est le temps de charge connu et R/C définit un relais temporisateur RC composé d'une résistance et du condensateur, qui fixe une constante de temps $\tau = R*C$ suivant laquelle le condensateur (C1 ; C1, C2) se charge.

12. Procédé suivant l'une des revendication 9 à 11, **caractérisé en ce que** l'on répète des échantillonnages de la courbe de charge du condensateur (C1 ; C1, C2) cycliquement à des temps d'échantillonnage définis.

13. Procédé suivant l'une des revendications 9 à 12, **caractérisé en ce que** l'on bloque l'interrupteur (T1 ; T1, T2) électronique jusqu'à charge complète du condensateur (C1 ; C1, C2), on détecte ensuite la valeur absolue de la tension ($U_{Ref}$) de référence et, sur la base de la valeur détectée de la tension ($U_{Ref}$) de référence, on étalonne au moins un canal de convertisseur analogique-numérique de la microunité (μC) de commande.

**FIG. 1**

**FIG. 2A**

**FIG. 2B**

**FIG. 3**

**FIG. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013226429 A1
- WO 2009040216 A2